# EUROPÄISCHE PATENTSCHRIFT

(11) **EP 0 835 332 B1**
(45) Veröffentlichungstag und Bekanntmachung des Hinweises auf die Patenterteilung: **03.05.2000**
(21) Anmeldenummer: 96923890.6
(22) Anmeldetag: 22.06.1996
(51) Int. Cl.: C23C 16/02, C23C 16/30, B05D 7/24

(54) **PLASMAPOLYMER-OBERFLÄCHENSCHICHT UND DAMIT BESCHICHTETER WÄRMEÜBERTRAGER**
PLASMAPOLYMER SURFACE COATING AND HEAT EXCHANGER COATED THEREWITH
COUCHE SUPERFICIELLE DE PLASMAPOLYMERE ET ECHANGEUR THERMIQUE REVETU DE CETTE COUCHE

(30) Priorität: 27.06.1995 DE 19523208
(43) Veröffentlichungstag der Anmeldung: 15.04.1998
(73) Patentinhaber: Behr GmbH & Co., 70469 Stuttgart (DE); Fraunhofer-Gesellschaft zur Förderung der angewandten Forschung e.V., 80636 München (DE)
(72) Erfinder: JUNG, Matthias, 70469 Stuttgart (DE); WALTER, Christoph, 70199 Stuttgart (DE); BAALMANN, Alfred, 27711 Heilshorn (DE); KRUSE, Alexander, 28790 Schwanewede (DE); STUKE, Henning, 28359 Bremen (DE); VISSING, Klaus-Dieter, 27321 Morsum (DE)
(74) Vertreter: Weller, Erich W.
(86) Internationale Anmeldenummer: EP9602719
(87) Internationale Veröffentlichungsnummer: WO9701656

(56) Entgegenhaltungen:
- EP-A- 0 533 606
- EP-A- 0 563 474
- EP-A- 0 570 944
- PATENT ABSTRACTS OF JAPAN vol. 014, no. 280 (C-0729), 18.Juni 1990 & JP,A,02 085357 (MATSUSHITA REFRIG CO LTD), 26.März 1990,

## Beschreibung

Die Erfindung bezieht sich auf eine Plasmapolymer-Oberflächenschicht, die mittels Niedertemperaturplasmapolymerisation unter Zufuhr eines gasförmigen Monomers auf einer Substratoberfläche abgeschieden ist und mehrere abrupt oder graduell aufeinanderfolgende Schichtlagen beinhaltet, sowie auf einen mit einer solchen Oberflächenschicht beschichteten Wärmeübertrager, insbesondere einen Verdampfer einer Fahrzeugklimaanlage.

Verdampfer für Fahrzeugklimaanalgen sind beispielsweise als sogenannte Scheibenverdampfer geläufig, die aus mehreren aneinandergereihten und fluiddicht miteinander verbundenen Scheibenkörpern aus Aluminium aufgebaut sind. Ein Verdampfer dieser Art ist beispielsweise in der Patentschrift US 5 086 832 beschrieben. Bei Wärmeübertragern dieser Art besteht häufig das Problem, daß sich an der äußeren Wärmeübertrageroberfläche Feuchtigkeit, z.B. aus einem vorbeiströmenden Luftstrom, niederschlägt und sich auf der feuchten Oberfläche Mikroorganismen, insbesondere Bakterien ansiedeln, die eine unerwünschte Geruchsbildung zur Folge haben. Als Abhilfe ist es bereits bekannt, die Aluminiumoberfläche von Verdampfern zu chromatieren und/oder mit einer Oberflächenlackschicht aus Epoxidharz oder Polyurethan zu versehen. Hierbei ist es bekannt, die Lackschicht durch ein Tauchlackierverfahren aufzubringen, wobei letztlich Schichtdicken im Bereich von ca. 500nm bis 1500nm erzielt werden. Zwar können mit einer solchen Beschichtung, die eine bakterizide Wirkung zeigt, der Bakterienbewuchs und damit die Geruchsentwicklung deutlich vermindert werden, jedoch ergeben sich Schwierigkeiten hinsichtlich höherer Wasserspeicherung und damit geringerer Wasserabscheidung sowie hinsichtlich verminderter Wärmeübertragungsleistung. Insbesondere die letztgenannte Schwierigkeit konnte bislang nicht zufriedenstellend behoben werden. Im Vergleich zur blanken Aluminiumoberfläche ergibt sich eine Verringerung der Kälteleistung der mit der herkömmlichen Polyurethan-Oberflächenschicht versehenen Verdampfer von mindestens 5%. Außerdem bieten derartige Lackschichten keinerlei Korrosionsschutz.

Es ist andererseits bekannt, polymerähnliche Schichten als Haftvermittlerschicht auf ein Grundmaterial mittels der sogenannten Niedertemperaturplasmapolymerisation aufzubringen, um für eine anschließend aufzutragende Lackschicht eine verbesserte Haftung zu erzielen. Bei dieser Beschichtungstechnik wird in das Plasma ein Monomer eingebracht, das sich dann unter Polymerisation als Polymer an der zu beschichtenden Oberfläche abscheidet. Mit dieser Methode können Beschichtungen aus nahezu jedem organischen Material, das in die Gasphase überführt werden kann, hergestellt werden, insbesondere auch aus Substanzen wie Methan, Benzol, Ferrocen, Hexamethyldisiloxan usw., die mit konventionellen Verfahren nicht polymerisiert werden können. Diese sogenannten Plasmapolymer-Schichten sind, abhängig von den Verfahrensbedingungen, meist hoch vernetzt und damit wasserunlöslich sowie wenig oder nicht quellend. Außerdem sind Plasmapolymere im Vergleich zu konventionell hergestellten Polymeren thermisch sehr stabil. Mit der Niedertemperaturplasmapolymerisation lassen sich porenfreie Schichten in einer relativ geringen Dicke bis herunter in den Bereich von etwa lOnm auf beliebig geformten Substraten erzeugen. Beschichtungsverfahren zum Aufbringen von haftvermittelnden Schichten mittels Niedertemperaturplasmapolymerisation sind beispielsweise in A. Moshonov und Y. Avny, J. Appl. Polym. Sci. 25 (5), (1980), Seite 771 und in einer Firmenschrift der Firma plasma-electronic GmbH, Filderstadt, mit dem Titel "Oberflächenvorbehandlung beim Kfz-Bau durch Niederdruckplasma-Verfahren" von H. Grünwald und G. Stipan beschrieben.

Eine Plasmapolymer-Oberflächenschicht der eingangs genannten Art ist in der Offenlegungsschrift EP 0 617 143 A1 offenbart, wobei sich mit dem dortigen Verfahren bahnförmige Substrate beschichten lassen. Die dortige Oberflächenschicht beinhaltet eine innere, dominant organische Schichtlage, eine mittlere Schichtlage mit mehr mineralischem Charakter und eine äußere, dominant organische Schichtlage, die der inneren entsprechen kann. Die innere und die äußere Schichtlage sind so gebildet, daß sie ein stärker hydrophobes Verhalten zeigen, so daß die äußere Schichtlage einen geeigneten Untergrund für eine aufzubringende Lackschicht bildet, während die mittlere Schichtlage eine höhere mechanische Festigkeit aufweist. Die innere Schichtlage dient der Bereitstellung einer ausreichenden Haftfähigkeit zum Substratuntergrund, wobei ein gradueller Übergang vom mehr organischen Verhalten der inneren zu mehr mineralischen Verhalten der mittleren Schichtlage vorgesehen sein kann. Die Oberflächenschicht besitzt eine Dicke zwischen 200nm und 250nm und dient als Korrosionsbarriere für eisenhaltige Substrate, die mit einer Zink/Nickel-Legierung oder anderen galvanischen Überzügen bedeckt sind. Der Druck in der Plasmakammer wird während der Beschichtung im Bereich zwischen etwa 0,1 Pa und 1000 Pa gehalten. Als Monomere für die mittlere Schichtlage mit ausgeprägt mineralischem Verhalten werden solche vorgeschlagen, die Silizium und Sauerstoff enthalten, z.B. Silane und Siloxane.

In der Patentschrift US 4 981 713 ist die Beschichtung von Stahlteilen mittels Niedertemperaturplasmapolymerisation zur Erzielung eines Korrosionsschutzes offenbart. Als Monomere werden insbesondere Organosilane, Kohlenwasserstoffe und Organometalle vorgeschlagen. Bei Bedarf wird eine Vorbehandlung mit einem O₂-Plasma durchgeführt.

In der Offenlegungsschrift JP 5-295563 (A) ist angegeben, daß sich eine Oberflächenschicht aus einem durch Oxidation und Polymerisation einer Polysilanverbindung erhaltenen, siliziumhaltigen Material als Beschichtung für ein metallisches Material mit hoher Korrosions- und Witterungsfestigkeit, Härte- und Haftfähigkeit eignet.

In der Offenlegungsschrift JP 2-85357 (A) ist ein Wärmeübertrager-Rippenmaterial offenbart, das mit einer Fluorharz-Schutzschicht versehen ist, durch die feine Kondenswassertropfen schon mit einem Durchmesser von etwa 1nm an der Rippenoberfläche nach unten laufen und nicht an der Oberfläche verbleiben. Dadurch soll einer Verringerung des Wirkungsgrads des Wärmeübertragers entgegengewirkt und ein Verstopfen der Rippen verhindert werden. Die Fluorharz-Schutzschicht wird durch Plasmapolymerisation spezieller, fluorhaltiger Monomere auf dem Rippenmaterial, das z.B. aus A1 besteht, aufgebracht.

Eine hohe Härte, geringe Porösität, gute Haftfähigkeit, ein hoher Brechungsindex, hydrophobes Verhalten, gute Isolationseigenschaften und Transparenz sind auch von Schichten bekannt, die durch plasmaunterstützte chemische Gasphasenabscheidung fluorierter, zyklischer Siloxane gebildet sind, wie in der Patentschrift US 5 230 929 offenbart.

In der Offenlegungsschrift EP 0 570 944 A1 sind ein Verfahren zur Oberflächenbeschichtung von Silbergegenständen und eine demgemäß hergestellte Schutzschicht offenbart. Der Beschichtungsvorgang erfolgt in einer Plasmapolymerisationsanlage mit kontinuierlicher Gaszufuhr und Gasaustausch der eingesetzten Monomeren, wobei in einem ersten Schritt eine Oberflächenbehandlung stattfindet und in weiteren Schritten die Oberfläche mit einer Gradientenschicht versehen wird. Die Gradientenschicht kann aus einer Kopplungsschicht, gefolgt von einer permeationsverhindernden Schicht und einer Oberflächenversiegelungsschicht bestehen. Die z.B. mittels Plasmaabscheidung in Gegenwart von Ethylen oder Vinyltrimethylsilan aufgebrachte Kopplungsschicht leitet im atomaren Bereich von einer metallischen zu einer kovalenten Bindung über. Durch Einstellen geeigneter Plasmabedingungen wird anschließend die permeationsverhindernde Schicht z.B. unter Verwendung von Ethylen als plasmabildendes Gas aufgebracht. Anschließend wird die Oberflächenversiegelungsschicht unter Verwendung z.B. von Hexamethyldisiloxan in Verbindung mit Sauerstoff aufgebracht, wobei die gewünschte Kratzfestigkeit z.B. durch ein O₂/Hexamethyldisiloxan-Mischungsverhältnis von 5:1 erreicht wird.

Aus der Offenlegungsschrift EP 0 563 474 A1 ist ein Scheibenverdampfer bekannt, der außenseitig mit einem hydrophilen Harz beschichtet ist, das in einem zugehörigen Tauchbeschichtungsvorgang aufgebracht wird.

Der Erfindung liegt als technisches Problem die Bereitstellung einer Plasmapolymer-Oberflächenschicht der eingangs genannten Art sowie eines damit beschichteten Wärmeübertragers dergestalt zugrunde, daß die Schicht eine gute Haftfähigkeit besitzt, ein gutes Wasserabscheidungsverhalten mit bakterizider und fungizider Wirkung zeigt und einen Korrosionsschutz bietet, ohne aus toxikologischen und ökologischen Gesichtspunkten problematische metallorganische Verbindungen zu benötigen, und die darüber hinaus die Wärmeübertragungsleistung eines damit beschichteten Wärmeübertragers nicht wesentlich mindert.

Die Erfindung löst dieses Problem durch die Bereitstellung einer Plasmapolymer-Oberflächenschicht mit den Merkmalen des Anspruchs 1 sowie eines Wärmeübertragers mit den Merkmalen des Anspruchs 3.

Die Plasmapolymer-Oberflächenschicht nach Anspruch 1 mit der z.B. die Außenfläche eines Verdampfers einer Fahrzeugklimaanlage beschichtet sein kann, beinhaltet drei abrupt oder graduell mit fließendem Übergang aufeinanderfolgende Schichtlagen, die in einer Plasmapolymerisationsanlage vorzugsweise in-situ in einem kontinuierlichen Prozeß in unterschiedlicher Weise abgeschieden werden. Eine innere Schichtlage ist so gebildet, daß sie kovalente Bindungen aufweist, welche die erforderliche Haftvermittlung zur Substratoberfläche bereitstellen, wobei sich die Verwendung der Monomere Methan, Ethylen, Acetylen, Toluol, Styrol und Vinyltrimethylsilan als besonders geeignet erweist. Im Anschluß daran wird eine mittlere Schichtlage gebildet, wobei der Beschichtungsprozeß so eingestellt wird, daß diese Schichtlage dicht vernetzt aufwächst und dadurch ein wasserdampfpermeationsverhinderndes Verhalten zeigt. Dabei kann gegebenenfalls ein anderes Monomer als für die innere Schichtlage verwendet werden, wobei im zugeführten Gasstrom optional Sauerstoff, Chlor oder Fluor enthalten sein kann. Mit dieser Wasserdampf-Barrierenschichtlage bietet die Oberflächenschicht einen Korrosionsschutz für die damit beschichtete Substratoberfläche. Auf die mittlere ist eine äußere Schichtlage mit hydrophilem Verhalten aufgebracht, wozu bei der Schichtherstellung im zugeführten Gasstrom ein geeignetes Monomer sowie Sauerstoff, Chlor oder Fluor oder eine Mischung derselben vorgesehen wird. Es zeigt sich, daß durch diese hydrophile Außenhaut der Oberflächenschicht die Wassertropfenbildung erschwert wird, da die Flüssigkeit auf der Schichtoberfläche zu einem flachen Film spreitet und dadurch besser abläuft, ohne zuvor große Tropfen zu bilden. Damit sowie gegebenenfalls durch eine relativ hohe Si-Konzentration in der äußeren Schichtlage wird eine bakterizide Wirkung erzielt, wie sie z.B. für Außenflächen von Verdampfern in Fahrzeugklimaanlagen erwünscht ist, ohne daß hierfür metallorganische Verbindungen eingesetzt werden müssen.

Die erfindungsgemäße Plasmapolymer-Oberflächenschicht besitzt eine Gesamtschichtdicke von weniger als 200nm. Dies ist wesentlich weniger als die Dicke herkömmlicher, mittels Tauchlackierung auf Verdampferaußenflächen aufgebrachter Polyurethan-Oberflächenschichten, so daß die Oberflächenschicht die Wärmeübertragungsleistung nicht wesentlich mindert.

Bei einer nach Anspruch 2 weitergebildeten Plasmapolymer-Oberflächenschicht ist die Wasserdampfdurchlässigkeit der mittleren Schichtlage bei Raumtemperatur kleiner als 5g/m²d und/oder die Festkörperoberflächenspannung der äußeren Schichtlage ist größer als 50mN/m.

Vor dem Aufbringen der Oberflächenschicht kann eine Plasmareinigung der zu beschichtenden Substratoberfläche durchgeführt werden.

Mit der erfindungsgemäßen Oberflächenschicht lassen sich auch komplexe, enge, dreidimensionale Substratoberflächenstrukturen, wie z.B. die Außenfläche eines Verdampfers mit einer wärmeübertragenden Rippenstruktur mit sehr feinen, kiemenartigen Luftströmungsschlitzen, gleichmäßig mit der Plasmapolymer-Oberflächenschicht beschichten, indem ein jeweils geeigneter Monomer-Gasstrom nicht einfach ungerichtet in die Reaktionskammer eingeleitet und wieder abgepumpt, sondern gerichtet über die Substratoberfläche hinweggeführt und/oder das Substrat im Plasma während der Beschichtung bewegt wird.

Für das zugehörige Beschichtungsverfahren kann eine negative Vorspannung zwischen -20V und -400V, vorzugsweise zwischen - 100V und -200V, am Substrat eingestellt werden.

Eine bevorzugte Ausführungsform der Erfindung ist in den Zeichnungen dargestellt und wird nachfolgend beschrieben. Hierbei zeigen:
- Fig. 1: eine schematische Teilansicht eines Scheibenverdampfers für eine Fahrzeugklimaanlage und
- Fig. 2: eine ausschnittweise Teilansicht der Außenfläche des Verdampfers von Fig. 1.

Der gezeigte Scheibenverdampfer besteht aus einem Aluminiumkörper herkömmlicher Bauart mit beabstandet nebeneinanderliegenden, hohlen Scheibenkörpern (2). Jeder Scheibenkörper (2) ist aus zwei aneinanderliegenden Scheibenkörper-Halbschalen (1) aufgebaut, die unter Bildung zwischenliegender Fluidströmungskanäle jeweils randseitig fluiddicht aneinandergelötet sind. Die Fluidströmungskanäle stehen jeweils mit einem Zuflußstutzen (4) und einem Abflußstutzen (5) zur Durchleitung eines Kältemittels in der gezeigten Pfeilrichtung (6) in Fluidverbindung. Benachbarte Scheibenkörper (2) sind jeweils über eine wärmeübertragende Rippenstruktur (3) voneinander beabstandet, die zwecks hoher Wärmeübertragungsleistung in nicht näher gezeigter Weise sehr feine, kiemenartige Luftströmungsschlitze aufweist. In einer typischen Ausführung besitzt der Scheibenverdampfer eine Bautiefe von etwa 65mm.

Nach Fertigstellung des Aluminiumkörpers des Verdampfers wird dieser in eine Beschichtungskammer einer Anlage zur Niedertemperaturplasmapolymerisation eingebracht, in welcher zunächst ein Reinigungsschritt durchgeführt wird, bei dem die zu beschichtende Verdampferaußenfläche durch ein abtragendes Plasma unter Zugabe eines Reinigungsgases, wie Argon, Sauerstoff, Wasserstoff oder eines fluorhaltigen Gases, gereinigt wird. Anschließend wird die gereinigte Oberfläche mit einer Plasmapolymer-Oberflächenschicht versehen, deren Dicke weniger als 200nm beträgt. Zum Aufbringen dieser Schicht wird von den Materialien und Prozeßparametern ausgegangen, die bislang für das Vorbeschichten bzw. das Aufbringen von haftvermittelnden Schichten mit dieser Depositionstechnik bekannt sind. Für nähere Details hierzu kann auf die diesbezüglich oben angegebene Literatur verwiesen werden.

Kurzgefaßt wird bei diesem Verfahren bei niedriger Temperatur und niedrigem Druck durch Anlegen einer elektrischen Spannung ein Plasma beispielsweise durch Glimmentladung erzeugt und nach Evakuierung der Beschichtungskammer ein gasförmiges Monomer gegebenenfalls in Verbindung mit weiteren Gasen eingeleitet. Durch die Einwirkung des Plasmas werden die Monomermoleküle aufgespalten, und es entstehen offene Bindungsbrükken. Die damit bindungsbereit gemachten Moleküle lagern sich als Niederschlag auf der Aluminiumoberfläche des blanken Verdampferaluminiumkörpers ab und vernetzen dort zum entsprechenden Polymermaterial. Es zeigt sich, daß die Vernetzung zur Aluminiumoberfläche bei geeigneter Prozeßeinstellung chemisch sehr stabil ist und sich die Endqualität der entstandenen polymeren Oberflächenschicht je nach Bedarf durch variable Einstellung der Prozeßparameter zwischen sehr hart, etwa entsprechend Quarzglas, und sehr weich, d.h. etwa silikonähnlich, einstellen läßt.

Als variierbare Prozeßparameter sind insbesondere die Plasmaleistung, der Druck und der Durchfluß des in das Plasma eingeführten Gasstroms sowie die geometrische Anordnung des Substrates, d.h. hier des Verdampfers, in der Beschichtungskammer zu nennen. Zudem ist eine gerichtete Einströmung des monomerhaltigen Gases über die zu beschichtende Substratoberfläche hinweg derart vorgesehen, daß auch komplexe, enge, dreidimensionale Substratoberflächen, wie die vorliegende Verdampferaußenfläche, gleichmäßig mit der Plasmapolymer-Oberflächenschicht versehen werden können. Bei Bedarf kann zu diesem Zweck zusätzlich vorgesehen sein, das Substrat in der Beschichtungskammer während der Beschichtung zu bewegen.

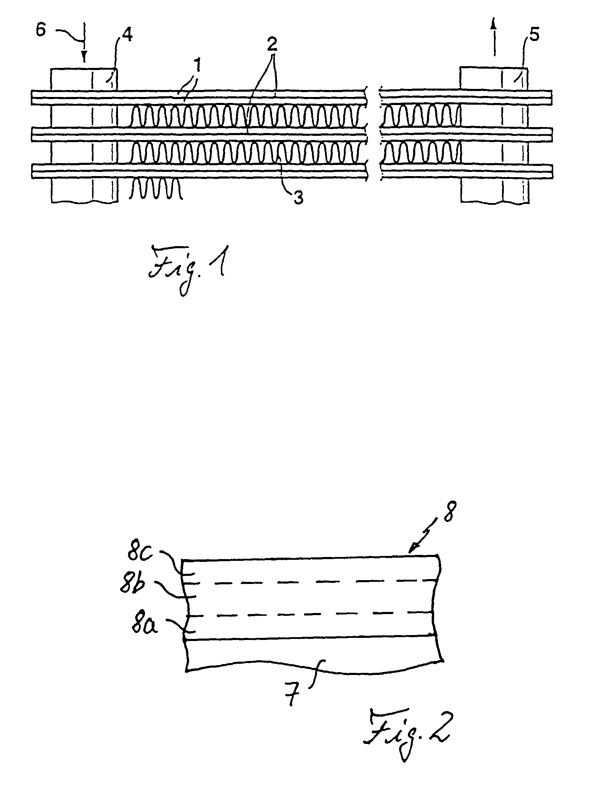

Fig. 2 zeigt schematisch im Ausschnitt die auf den Verdampferaluminiumkörper (7) außenseitig aufgebrachte Plasmapolymer-Oberflächenschicht (8), die eine innere, haftvermittelnde Schichtlage (8a), eine mittlere, wasserdampfpermeationsverhindernde Schichtlage (8b) und eine äußere, hydrophile Schichtlage (8c) umfaßt. Die zwischenliegenden, gestrichelten Grenzlinien sollen andeuten, daß der Übergang zwischen den einzelnen Schichtlagen (8a bis 8c) vorzugsweise graduell erfolgt, daß also der Übergang von der einen zur nächsten Schichtlage fließend ist. Alle drei Schichtlagen werden in-situ in einem kontinuierlichen Plasmapolymerisationsprozeß nacheinander aufgebracht, wobei die Prozeßparameter jeweils passend eingestellt werden und gegebenenfalls die Zusammensetzung des in die Beschichtungskammer gerichtet eingeleiteten Gasstroms kontinuierlich geändert wird. Der Druck des Gases oder Gasgemisches, in welchem das Niederdruckplasma erzeugt wird, wird für alle Schichtlagen (8a) bis (8c) im Bereich von 0,01mbar bis 15mbar, vorzugsweise zwischen 0,lmbar und 15mbar eingestellt. Die Vorspannung wird im Bereich zwischen -20V und -400V, vorzugsweise zwischen -100V und -200V, extern oder durch Wahl der zugeführten Leistung eingestellt. Das Plasma kann durch Gleichspannungs-, Niederfrequenz-, Hochfrequenz-, Mikrowellen- oder Mikrowellen-ECR-Entladungen bzw. in kombinierter Hochfrequenz- und Mikrowellenenergie erzeugt werden. Ein vorteilhafter Beschichtungsvorgang wird nachstehend exemplarisch angegeben.

Zum Aufbringen der inneren Schichtlage (8a) wird das Gas des Plasmareinigungsschrittes kontinuierlich durch ein Gas ersetzt, welches für die Bildung dieser Schichtlage (8a) als eine solche mit kovalenten Bindungen geeignet ist, so daß diese Schichtlage (8a) haftvermittelnde Eigenschaften besitzt. Hierfür geeignete Monomere sind z.B. Methan, Ethylen, Acetylen, Toluol, Styrol und Vinyltrimethylsilan. Das bevorzugte Monomer für diese haftvermittelnde Schichtlage (8a) ist Ethylen.

Gegen Ende des Abscheidungsvorgangs für diese erste Schichtlage (8a) wird der bisherige Monomer-Gasstrom kontinuierlich durch einen Monomer-Gasstrom ersetzt, der zur Bildung der mittleren, wasserdampfpermeationsverhindernden Schichtlage (8b) geeignet ist. In Betracht kommen hier als Monomere beispielsweise Ethylen, Hexamethyldisiloxan und Octafluorocyclobutan sowie Mischungen hiervon. Außerdem kann der dem Plasma zugeführte Gasstrom optional Sauerstoff, Chlor oder Fluor enthalten. Bevorzugt ist für die Bildung dieser Schichtlage (8b) die Verwendung eines siliziumorganischen Monomers, wie Hexamethyldisiloxan, in Mischung mit Sauerstoff. Zusätzlich oder alternativ zu diesem kontinuierlichen Monomeraustausch werden die Beschichtungsprozeßparameter kontinuierlich so geändert, daß die mittlere Schichtlage (8b) als gegenüber der darunterliegenden, haftvermittelnden Schichtlage (8a) dichter vernetzte Schichtlage aufwächst, um die Wasserdampfbarrierenfunktion zu erfüllen. Dies verleiht der Plasmapolymer-Oberflächenschicht (8) Korrosionsschutzeigenschaften. Es zeigt sich, daß die Wasserdampfdurchlässigkeit der auf diese Weise aufgebrachten Schichtlage (8b) bei Raumtemperatur kleiner als 5g/m²d ist.

Gegen Ende der Abscheidung der mittleren Schichtlage (8b) wird wiederum kontinuierlich auf die Abscheidung der äußeren, hydrophilen Schichtlage (8c) übergegangen, für die als Monomer vorzugsweise Ethylen, Hexamethyldisiloxan oder Octafluorocyclobutan in das Plasma eingeleitet wird. Zusätzlich enthält der in das Plasma geführte Gasstrom Sauerstoff, Chlor oder Fluor, z.B. in Form von sauerstoff-, chlor- oder fluorhaltigen Monomeren, was der damit abgeschiedenen, äußeren Schichtlage (8c) ihre hydrophile Eigenschaft verleiht. Die abgeschiedene, hydrophile Schichtlage (8c) zeigt Festkörperoberflächenspannungen im Bereich größer als 50mN/m. Gute Schichteigenschaften für die hydrophile Schichtlage (8c) haben sich insbesondere bei Verwendung eines siliziumorganischen Monomers oder Methan in Mischung mit Sauerstoff gezeigt. Die hydrophile Außenhaut der Plasmapolymer-Oberflächenschicht (8) bewirkt, daß darauf kondensierendes Wasser einen sehr dünnen Film bilden kann und dadurch sehr leicht von der Oberfläche abläuft, ohne größere Tropfen zu bilden. Aus dieser Tatsache erklärt sich eine für die Plasmapolymer-Oberflächenschicht (8) beobachtete, bakterizide Wirkung, die weiter dadurch unterstützt sein kann, daß in der äußeren Schichtlage (8c) Silicium in relativ hoher Konzentration eingebracht wird.

Auf die beschriebene Weise kann die Plasmapolymer-Oberflächenschicht (8) als multifunktionelle Mehrlagenschicht mit hydrophiler, wasserdampfpermeationsverhindernder und haftvermittelnder Charakteristik in einem kontinuierlichen Plasmapolymerisationsprozeß aufgebracht werden. Die Oberflächenschicht (8) ist chemisch resistent und transparent und besitzt ohne Einsatz metallorganischer Verbindungen eine bakterizide Wirkung. Sie ist gleichmäßig geschlossen auch in denjenigen Bereichen der Verdampferaußenfläche gebildet, in denen durch die Rippen- oder Kiemenstruktur des Verdampfers keine direkte Plasmaeinwirkung vorliegt. Sie kann zudem unabhängig von der Vorbehandlung des Substratmaterials, insbesondere unabhängig von einer Gelb- oder Grünchromatierung oder einer Nokoloklötung des Substratmaterials - wie dies für solche Verdampfer üblich ist -, aufgebracht werden.

Es versteht sich, daß neben dem gezeigten Scheibenverdampfer auch beliebige andere Substrate bei Bedarf mit der erfindungsgemäßen Plasmapolymer-Oberflächenschicht versehen werden können.

## Patentansprüche

1. Plasmapolymer-Oberflächenschicht, insbesondere für einen Verdampfer einer Fahrzeugklimaanlage, die mittels Niedertemperaturplasmapolymerisation unter Zufuhr eines Monomer-Gasstroms auf einer Substratoberfläche abgeschieden ist und mehrere abrupt oder graduell aufeinanderfolgende Schichtlagen beinhaltet,
**dadurch gekennzeichnet, daß**
- ihre Schichtdicke weniger als 200nm beträgt, wobei eine innere, substratseitige Schichtlage (8a) mit kovalenten, haftvermittelnden Bindungen eine Schichtdicke von weniger als 50nm aufweist, eine mittlere, dicht vernetzt aufgewachsene, wasserdampfpermeationsverhindernde Schichtlage (8b) eine Schichtdicke von weniger als 100nm aufweist und eine äußere Schichtlage (8c) mit hydrophilem Verhalten, zu deren Bildung ein sauerstoff-, chlor- oder fluorhaltiger Monomer-Gasstrom verwendet wird, eine Schichtdicke von weniger als 50nm aufweist.

2. Plasmapolymer-Oberflächenschicht nach Anspruch 1, weiter dadurch gekennzeichnet, daß die Wasserdampfdurchlässigkeit der mittleren Schichtlage (8b) bei Raumtemperatur kleiner als 5g/m²d ist und/oder die Festkörperoberflächenspannung der äußeren Schichtlage (8c) größer als 50mN/m ist.

3. Wärmeübertrager, insbesondere Verdampfer für eine Fahrzeugklimaanlage, dadurch gekennzeichnet, daß die von der zu klimatisierenden Luft beaufschlagte Oberfläche des nach Anspruch 1 oder 2 Wärmeübertragers mit einer Plasmapolymer-Oberflächenschicht beschichtet ist.

## Claims

1. Plasma polymer surface film, particularly for an evaporator in a vehicle air-conditioning system, which is deposited on a substrate surface by low-temperature plasma polymerisation by the infeed of a flow of monomer gas and which comprises a plurality of layers which succeed one another either abruptly or gradually,
**characterised in that**
- the thickness of this film is less than 200 nm, there being an inner layer (8a) of the film next to the substrate, which makes covalent, adhesion-promoting bonds and which has a film thickness of less than 50 nm, a central layer (8b) of the film which has been so formed as to be densely cross-linked and which prevents the permeation of water vapour and which has a film thickness of less than 100 nm, and an outer layer (8c) of the film possessing hydrophilic characteristics, to form which a flow of monomer gas containing oxygen, chlorine or fluorine is used and which has a film thickness of less than 50 nm.

2. Plasma polymer surface film according to claim 1, further characterised in that the permeability to water vapour of the central layer (8b) of the film at ambient temperature is less than 5 g/m²d and/or the solid-state surface tension of the outer layer (8c) of the film is more than 50 mN/m.

3. Heat transmitting device, particularly an evaporator for a vehicle air-conditioning system, characterised in that the surface of the heat transmitting device which is contacted by the air to be conditioned is coated with a plasma polymer surface film according to claim 1 or 2.

## Revendications

1. Un revêtement de surface en plasma polymérisé, destiné en particulier aux évaporateurs de climatisation de véhicules automobiles, qui est déposé sur la surface d'un substrat par polymérisation de plasma à basse température avec l'apport d'un flux de gaz monomère, et qui comporte plusieurs couches abruptes ou graduelles superposées, **revêtement caractérisé par le fait que**
- son épaisseur est inférieure à 200 nm, et où une couche interne côté substrat (8a) adhère par des liaisons de covalence et possède une épaisseur inférieure à 50 nm, une couche moyenne (8b) très dense empêche toute pénétration de vapeur d'eau et possède une épaisseur inférieure à 100 nm, et une couche externe (8c) hydrophile réalisée à l'aide de l'apport d'un flux de gaz monomère enrichi à l'oxygène, au chlore ou au fluor, et dont l'épaisseur est inférieure à 50 nm.

2. Un revêtement de surface en plasma polymérisé suivant la revendication 1, et caractérisé plus loin par le fait que la perméabilité à la vapeur d'eau, à température ambiante, de la couche moyenne (8b) est inférieure à 5 g/m³d, et/ou la tension superficielle de la matière solide de la couche externe (8c) est supérieure 50 mN/m.

3. Dispositif caloporteur, et principalement évaporateur pour une climatisation de véhicule automobile, caractérisé par le fait que la surface du dispositif caloporteur qui traite l'air à climatiser est recouverte d'un revêtement en plasma polymérisé conformément aux revendications 1 ou 2.
